# EUROPEAN PATENT APPLICATION

(11) **EP 4 730 976 A1**
(43) Date of publication of application: **22.04.2026**
(21) Application number: 25203925.0
(22) Date of filing: 23.09.2025
(51) Int. Cl.: H10K 85/50, H10K 71/12, H10K 30/40

(54) **METHOD FOR MANUFACTURING PHOTOVOLTAIC CELL AND PRECURSOR SOLUTION OF PEROVSKITE COMPOUND**

(30) Priority: 15.10.2024 JP 2024180266
(71) Applicant: Toyota Jidosha Kabushiki Kaisha, Toyota-shi, Aichi-ken 471-8571 (JP)
(72) Inventor: MATSUNOBU, Kohei, Toyota-shi 471-8571 (JP); OKUMURA, Kenichi, Toyota-shi 471-8571 (JP)
(74) Representative: J A Kemp LLP

(57) **Abstract**

Provided is a method for manufacturing a perovskite-type photovoltaic cell that allows improving the power generation efficiency of photovoltaic cell. The photovoltaic cell includes a photoelectric conversion layer containing a perovskite compound represented by formula ABX₃, wherein, A represents at least one cation selected from the group consisting of Cs⁺, CH₃NH₃⁺, and HC(NH₂)₂⁺, B represents at least one divalent cation selected from the group consisting of Pb²⁺ and Sn²⁺, and X represents at least one anion selected from the group consisting of halide anions. The precursor solution used in the method contains A, B, X¹, and X² in a molar ratio of (1+a):1:3:a, wherein X¹ represents at least one anion selected from the group consisting of halide anions, X² represents Cl⁻, and ***a*** represents a real number greater than 0 and less than or equal to 0.13.

## Description

### BACKGROUND

### Technical Field

The present disclosure relates to a method for manufacturing a photovoltaic cell and a precursor solution of a perovskite compound.

### Background Art

As a type of photovoltaic cell, a perovskite-type photovoltaic cell having a photoelectric conversion layer primarily containing a perovskite compound has been known.

Japanese Patent No. 6263186 discloses the process for manufacturing a perovskite compound represented by the formula ABX_{3-y}X'_{y}, wherein A is an organic cation, B is a metal cation, X is a first halide anion, X' is a second halide anion which is different from the first halide anion, and y is from 0.05 to 2.95.

### SUMMARY

It is desirable that a perovskite-type photovoltaic cell have high power generation efficiency. In view of this, the present disclosure provides a method for manufacturing a perovskite-type photovoltaic cell that allows improvement of the power generation efficiency of the perovskite-type photovoltaic cell and a precursor solution of a perovskite compound used in the manufacturing method.

The present disclosure includes the following aspects.
[Aspect 1] A method for manufacturing a photovoltaic cell,
   wherein the photovoltaic cell includes:
   a photoelectric conversion layer containing a perovskite compound represented by formula (1) below:

      ABX₃ (1),
   wherein
      A represents at least one cation selected from the group consisting of Cs⁺, CH₃NH₃⁺, and HC(NH₂)₂⁺,
      B represents at least one divalent cation selected from the group consisting of Pb²⁺ and Sn²⁺, and
      X represents at least one anion selected from the group consisting of halide anions,
   the method comprising:
      applying a precursor solution onto an application surface to form a coating; and
      annealing the coating to form the photoelectric conversion layer,
   wherein the precursor solution contains A, B, X¹, and X² in a molar ratio of (1+a):1:3:a,
   wherein X¹ represents at least one anion selected from the group consisting of halide anions,
   wherein X² represents Cl⁻, and
   wherein ***a*** represents a real number greater than 0 and less than or equal to 0.13.
[Aspect 2] The method according to aspect 1,
   wherein X¹ represents at least one anion selected from the group consisting of Br⁻and I⁻.
[Aspect 3] The method according to aspect 1 or 2,
   wherein B represents Pb²⁺.
[Aspect 4] The method according to any one of aspects 1 to 3, further comprising
   dissolving at least one compound represented by formula (2) below, at least one compound represented by formula (3) below, and at least one compound represented by formula (4) below:

   AX¹ (2),

   BX¹₂ (3),

   and

   AX² (4),

   in a solvent to prepare the precursor solution.
[Aspect 5] The method according to any one of aspects 1 to 4,
   wherein ***a*** represents a real number greater than or equal to 0.03 and less than or equal to 0.1.
[Aspect 6] The method according to any one of aspects 1 to 5,
   wherein the photovoltaic cell further includes, in this order, a substrate, a first electrode layer, a first carrier transport layer, a second carrier transport layer, and a second electrode layer, and
   wherein the photoelectric conversion layer is disposed between the first carrier transport layer and the second carrier transport layer.
[Aspect 7] A precursor solution of a perovskite compound,
   wherein the precursor solution contains A, B, X¹, and X² in a molar ratio of (1+a):1:3:a,
   wherein A represents at least one cation selected from the group consisting of Cs⁺, CH₃NH₃⁺, and HC(NH₂)₂⁺,
   wherein B represents at least one divalent cation selected from the group consisting of Pb²⁺ and Sn²⁺,
   wherein X¹ represents at least one anion selected from the group consisting of halide anions,
   wherein X² represents Cl⁻, and
   wherein ***a*** represents a real number greater than 0 and less than or equal to 0.13.
[Aspect 8] The precursor solution according to aspect 7,
   wherein X¹ represents at least one anion selected from the group consisting of Br⁻and I⁻.
[Aspect 9] The precursor solution according to aspect 7 or 8,
   wherein B represents Pb²⁺,
[Aspect 10] The precursor solution according to any one of aspects 7 to 9,
   wherein ***a*** represents a real number greater than or equal to 0.03 and less than or equal to 0.1.

The manufacturing method according to the present disclosure allows improvement of the power generation efficiency of a perovskite-type photovoltaic cell.

### BRIEF DESCRIPTION OF THE DRAWINGS

FIG. 1 is a schematic cross-sectional view illustrating an exemplary structure of a photovoltaic cell;
FIG. 2 is a schematic diagram illustrating a perovskite-type crystalline structure;
FIG. 3 is a flowchart illustrating a method for manufacturing a photovoltaic cell according to an embodiment;
FIG. 4 is a graph illustrating the relationship between normalized power generation efficiency and a value ***a*** of photovoltaic cells of Examples 1 and 2 and Comparative Examples 1 to 3 manufactured using a precursor solution containing Cs⁺, HC(NH₂)₂⁺, CH₃NH₃⁺, Pb²⁺, I⁻, Br⁻, and Cl⁻ in a molar ratio of 0.05:0.79:(0.16+a):1:2.55:0.45:a;
FIG. 5 is a graph illustrating the relationship between the normalized power generation efficiency and the value ***a*** of photovoltaic cells of Examples 3 to 5 and Comparative Examples 1, 4, and 5 manufactured using a precursor solution containing Cs⁺, HC(NH₂)₂⁺, CH₃NH₃⁺, Pb²⁺, I⁻, Br⁻, and Cl⁻ in a molar ratio of 0.05:(0.79+a):0.16:1:2.55:0.45:a;
FIG. 6 is a graph illustrating the relationship between the normalized power generation efficiency and the value ***a*** of photovoltaic cells of Example 6 and Comparative Examples 1 and 6 manufactured using a precursor solution containing Cs⁺, HC(NH₂)₂⁺, CH₃NH₃⁺, Pb²⁺, I⁻, Br⁻, and Cl⁻ in a molar ratio of (0.05+a):0.79:0.16:1:2.55:0.45:a;
FIG. 7 is a graph illustrating the relationship between the normalized power generation efficiency and the value ***a*** of photovoltaic cells of Example 7 and Comparative Example 7 manufactured using a precursor solution containing Cs⁺, HC(NH₂)₂⁺, CH₃NH₃⁺, Pb²⁺, I⁻, and Cl⁻ in a molar ratio of 0.17:0.83:a:1:3:a;
FIG. 8 is a graph illustrating the relationship between the normalized power generation efficiency and the value ***a*** of photovoltaic cells of Example 8 and Comparative Example 7 manufactured using a precursor solution containing Cs⁺, HC(NH₂)₂⁺, Pb²⁺, I⁻, and Cl⁻ in a molar ratio of 0.17:(0.83+a):1:3:a;
FIG. 9 is a graph illustrating the relationship between the normalized power generation efficiency and the value ***a*** of photovoltaic cells of Example 9 and Comparative Example 7 manufactured using a precursor solution containing Cs⁺, HC(NH₂)₂⁺, Pb²⁺, I⁻, and Cl⁻ in a molar ratio of (0.17+a):0.83:1:3:a;
FIG. 10 is a graph illustrating the relationship between the ratio of perovskite (100) diffraction peak intensity to ITO (222) diffraction peak intensity and the value ***a***;
FIG. 11 is a planar SEM image of a photoelectric conversion layer manufactured by a method similar to that of Comparative Example 1;
FIG. 12 is a planar SEM image of a photoelectric conversion layer manufactured by a method similar to that of Example 1;
FIG. 13 is a planar SEM image of a photoelectric conversion layer manufactured by a method similar to that of Example 2;
FIG. 14 is a planar SEM image of a photoelectric conversion layer manufactured by a method similar to that of Comparative Example 2; and
FIG. 15 is a planar SEM image of a photoelectric conversion layer manufactured by a method similar to that of Comparative Example 3.

### DETAILED DESCRIPTION

The following description explains embodiments with reference to the drawings as necessary. In the drawings referenced herein, the dimensional proportions and shapes of respective members may be exaggerated for ease of explanation and may differ from their actual dimensional proportions and shapes. In this application, the term "on" encompasses both "directly on" and "indirectly on", unless otherwise specified in the context. The upper and lower limits of numerical ranges described herein may be used individually or in appropriate combination.

### I. Photovoltaic Cell

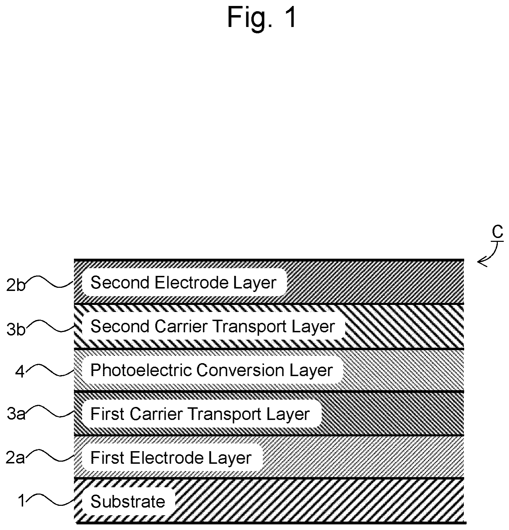

First, a perovskite-type photovoltaic cell (hereinafter, also simply referred to as a "photovoltaic cell") manufactured by a manufacturing method according to an embodiment described below is described. FIG. 1 is a schematic cross-sectional view illustrating an exemplary structure of the photovoltaic cell.

As illustrated in FIG. 1, in one embodiment, the photovoltaic cell C includes, in this order, a substrate 1, a first electrode layer 2a, a first carrier transport layer 3a, a photoelectric conversion layer 4, a second carrier transport layer 3b, and a second electrode layer 2b.

### (a) Photoelectric Conversion Layer 4

The photoelectric conversion layer 4 is disposed between the first carrier transport layer 3a and the second carrier transport layer 3b. The photoelectric conversion layer 4 generates charge carriers (electronic charge carriers) when it receives light. The charge carriers generated in the photoelectric conversion layer 4 move to either the first carrier transport layer 3a or the second carrier transport layer 3b.

Specifically, positive charge carriers (i.e., holes) generated in the photoelectric conversion layer 4 are transported to the first electrode layer 2a or the second electrode layer 2b, via either the first carrier transport layer 3a or the second carrier transport layer 3b, which functions as a hole transport layer. Negative charge carriers (i.e., electrons) generated in the photoelectric conversion layer 4 are transported to the first electrode layer 2a or the second electrode layer 2b, via either the first carrier transport layer 3a or the second carrier transport layer 3b, which functions as an electron transport layer.

The photoelectric conversion layer 4 contains a perovskite compound. The photoelectric conversion layer 4 may contain the perovskite compound as the main component. The content of the perovskite compound in the photoelectric conversion layer 4 may be 60 weight% or more, 80 weight% or more, 90 weight% or more, 95 weight% or more, or 100 weight%. The thickness of the photoelectric conversion layer 4 may be from 100 nm to 1000 nm.

The perovskite compound is typically represented by formula (1) below:

ABX₃ (1),

wherein A represents a monovalent cation, B represents a divalent cation, and X represents a monovalent anion.

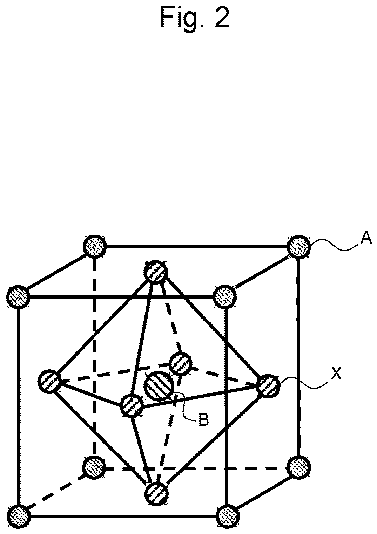

The perovskite compound has a perovskite-type crystalline structure. FIG. 2 is a schematic diagram illustrating the perovskite-type crystalline structure. As illustrated in FIG. 2, the perovskite-type crystalline structure has a unit cell of a cubic crystal system, with A positioned at each vertex, B at the body center, and X at each face center of the cubic crystal. Whether a compound has a perovskite-type crystalline structure can be confirmed by, for example, X-ray diffraction (XRD) analysis.

In one embodiment, in formula (1), A represents at least one cation selected from the group consisting of cesium cation (Cs⁺), methylammonium (MA) cation (CH₃NH₃⁺), and formamidinium (FA) cation (HC(NH₂)₂⁺). B represents at least one divalent cation selected from the group consisting of lead(II) cation (Pb²⁺) and tin(II) cation (Sn²⁺), and in some embodiments, it represents Pb²⁺. X represents at least one anion selected from the group consisting of halide anions, and in some embodiments, it represents at least one anion selected from the group consisting of fluoride anion (F⁻), chloride anion (Cl⁻), bromide anion (Br⁻), and iodide anion (I⁻), and in some embodiments, at least one anion selected from the group consisting of Cl⁻, Br⁻, and I⁻.

### (b) First Carrier Transport Layer 3a and Second Carrier Transport Layer 3b

The first carrier transport layer 3a accepts charge carriers generated in the photoelectric conversion layer 4 and transports the charge carriers to the first electrode layer 2a. When the first carrier transport layer 3a is the hole transport layer, the first carrier transport layer 3a transports holes to the first electrode layer 2a. When the first carrier transport layer 3a is the electron transport layer, the first carrier transport layer 3a transports electrons to the first electrode layer 2a.

The second carrier transport layer 3b accepts charge carriers generated in the photoelectric conversion layer 4 and transports the charge carriers to the second electrode layer 2b. When the second carrier transport layer 3b is the hole transport layer, the second carrier transport layer 3b transports holes to the second electrode layer 2b. When the second carrier transport layer 3b is the electron transport layer, the second carrier transport layer 3b transports electrons to the second electrode layer 2b.

The hole transport layer transports the holes generated by photoelectric conversion in the photoelectric conversion layer 4 to the first electrode layer 2a or the second electrode layer 2b. Any known organic or inorganic materials that can be used for hole transport layers can be used as the material of the hole transport layer.

Examples of the organic materials that can be used as the material of the hole transport layer include 2,2',7,7'-tetrakis-(N,N-di-4-methoxyphenylamino)-9,9'-spirobifluorene (Spiro-OMeTAD), Poly(3,4-ethylenedioxythiophene):poly(styrene sulfonate) (PEDOT:PSS), and poly[bis(4-phenyl)(2,4,6-trimethylphenyl)amine] (PTAA).

Examples of the inorganic materials that can be used as the material of the hole transport layer include nickel oxide and copper oxide.

The electron transport layer transports the electrons generated by photoelectric conversion in the photoelectric conversion layer 4 to the first electrode layer 2a or the second electrode layer 2b. Any known organic or inorganic materials that can be used for electron transport layers can be used as the material of the electron transport layer.

Examples of the organic materials that can be used as the material of the electron transport layer include fullerene compounds, phenanthroline derivatives (such as bathocuproine), and polyethylenimines. Examples of the fullerene compounds include fullerenes (such as C60 fullerene and C70 fullerene) and derivatives thereof in which substituents are added (such as [6,6]-phenyl-C₆₁-butyric acid methyl ester (also referred to as PCBM or [60]PCBM) and [6,6]-phenyl-C₇₁-butyric acid methyl ester (also referred to as PCBM or [70]PCBM)).

Examples of the inorganic materials that can be used as the material of the electron transport layer include titanium oxide, tin oxide, and zinc oxide.

In one embodiment, the first carrier transport layer 3a is the electron transport layer, and the second carrier transport layer 3b is the hole transport layer. In this embodiment, the photovoltaic cell C has the substrate 1, a cathode, the electron transport layer, the photoelectric conversion layer 4, the hole transport layer, and an anode, in this order. In this embodiment, the material of the hole transport layer may be Spiro-OMeTAD, PTAA, or nickel oxide. In this embodiment, the material of the electron transport layer may be fullerene, PCBM, bathocuproine, polyethylenimines, titanium oxide, or tin oxide.

In another embodiment, the first carrier transport layer 3a is the hole transport layer, and the second carrier transport layer 3b is the electron transport layer. In this embodiment, the photovoltaic cell C has the substrate 1, an anode, the hole transport layer, the photoelectric conversion layer 4, the electron transport layer, and a cathode, in this order. In this embodiment, the material of the hole transport layer may be PEDOT:PSS, PTAA, or nickel oxide. In this embodiment, the material of the electron transport layer may be fullerene, PCBM, bathocuproine, or polyethylenimines.

### (c) First Electrode Layer 2a and Second Electrode Layer 2b

The first electrode layer 2a is the electrode in contact with the first carrier transport layer 3a. The second electrode layer 2b is the electrode in contact with the second carrier transport layer 3b.

Any known materials that can be used for the electrodes of the photovoltaic cell C can be used as the materials of the first electrode layer 2a and the second electrode layer 2b. Examples of such materials include metal materials, such as aluminum (Al), silver (Ag), and gold (Au), transparent conductive materials, such as indium tin oxide (ITO), indium zinc oxide (IZO), aluminum-doped zinc oxide (AZO), and fluorine-doped tin oxide (FTO), and carbon nanotubes. The materials of the first electrode layer 2a and the second electrode layer 2b may be ITO, IZO, or FTO. If light enters the photovoltaic cell C through the surface of the substrate 1, the first electrode layer 2a may be transparent, and the second electrode layer 2b may be transparent or non-transparent. If light enters the photovoltaic cell C through the surface of the second electrode layer 2b, the first electrode layer 2a may be transparent or non-transparent, and the second electrode layer 2b may be transparent.

### (d) Substrate 1

The substrate 1 supports the first electrode layer 2a, the first carrier transport layer 3a, the photoelectric conversion layer 4, the second carrier transport layer 3b, and the second electrode layer 2b.

The substrate 1 may be in the form of a plate or film. Examples of the materials of the substrate 1 include inorganic materials, such as glass; organic materials, such as polyethylene, polyethylene terephthalate, polyethylene naphthalate, polyimide, polyamide, polyamide imide, liquid crystal polymers, and cycloolefin polymers; and metal materials, such as stainless steel and silicon.

The substrate 1 may be transparent or non-transparent. If light enters the photovoltaic cell C through the surface of the substrate 1, a transparent substrate is used. Examples of the transparent substrate include substrates made of glass, polyethylene terephthalate, polyethylene naphthalate, polyimide, polyamide, polyamide imide, or cycloolefin polymers. If light enters the photovoltaic cell C through the surface of the second electrode layer 2b, a non-transparent substrate may be used.

### II. Method for Manufacturing Photovoltaic Cell

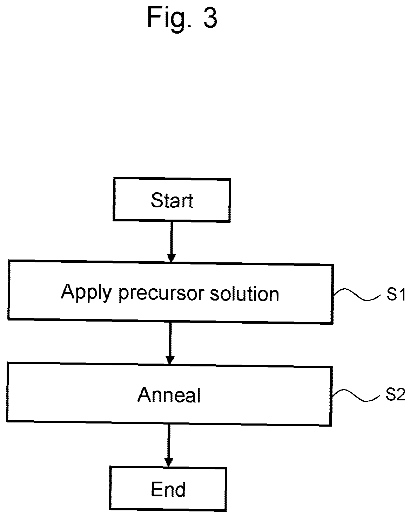

Next, a method for manufacturing a photovoltaic cell according to an embodiment is described. As illustrated in FIG. 3, the method for manufacturing the photovoltaic cell according to the embodiment includes applying a precursor solution onto an application surface to form a coating (S1) and annealing the coating to form a photoelectric conversion layer (S2).

In one embodiment, the method for manufacturing the photovoltaic cell optionally further includes forming a stacked body including a substrate, a first electrode layer, and a first carrier transport layer, in this order, before applying the precursor solution, and optionally further includes forming a second carrier transport layer and a second electrode layer on the photoelectric conversion layer, in this order, after forming the photoelectric conversion layer. In this embodiment, the precursor solution may be applied onto the first carrier transport layer. The first electrode layer, the first carrier transport layer, the second carrier transport layer, and the second electrode layer can be formed by a method similar to that used for forming these layers in a conventional photoelectric conversion element. Therefore, a detailed description of the method for forming these layers is omitted.

### (a) Application of Precursor Solution (S1)

A precursor solution is applied onto an application surface to form a coating. The application surface may be the surface of the first carrier transport layer. If the photovoltaic cell does not include a first carrier transport layer, the application surface may be the surface of the first electrode layer. If the photovoltaic cell includes any other layer between the photoelectric conversion layer and the first carrier transport layer, the application surface may be the surface of the other layer. That is, the application surface is selected as appropriate depending on the configuration of the photovoltaic cell to be manufactured.

The precursor solution contains a solute which is a precursor of the perovskite compound represented by the formula (1) above. The precursor solution contains A, B, X¹, and X² in a molar ratio of (1+a):1:3:a. Here, A represents at least one cation selected from the group consisting of Cs⁺, CH₃NH₃⁺, and HC(NH₂)₂⁺. B represents at least one divalent cation selected from the group consisting of Pb²⁺ and Sn²⁺. X¹ represents at least one anion selected from the group consisting of halide anions. X² represents Cl⁻, and ***a*** represents a real number greater than 0 and less than or equal to 0.13. In one embodiment, X¹ represents at least one anion selected from the group consisting of Br and I⁻. In one embodiment, B represents Pb²⁺. In one embodiment, ***a*** represents a real number greater than or equal to 0.03 and less than or equal to 0.13 or a real number greater than or equal to 0.03 and less than or equal to 0.1. X in formula (1) is derived from at least one of X¹ or X².

In one embodiment, the precursor solution can be prepared by dissolving at least one compound represented by formula (2) below, at least one compound represented by formula (3) below, and at least one compound represented by formula (4) below:

AX¹ (2),

BX¹₂ (3),

and

AX² (4),

wherein A, B, X¹, and X² are as defined above, in an appropriate solvent.

The solvent of the precursor solution may be a polar solvent from the aspect of solute solubility. In addition, the solvent of the precursor solution may be an aprotic solvent from the aspect of solute stability. Examples of solvents that can be used as the solvent of the precursor solution include N,N-dimethylformamide (DMF), dimethyl sulfoxide (DMSO), N-methylpyrrolidone (NMP), γ-butyrolactone, and mixed solvents containing one or more of these.

The precursor solution may be applied by any application method capable of forming a uniform coating. Examples of applicable application methods include the spin coating method, the inkjet method, the spray coating method, the blade coating method, and the die coating method.

From the aspect of the stability of the precursor solution, the application of the precursor solution may be performed in a dry air atmosphere, and, in some embodiments, in an inert gas atmosphere. The inert gas may be any gas that does not react with the solute of the precursor solution. Examples of the inert gas include nitrogen and argon.

A poor solvent may be applied onto the coating. The poor solvent is one in which the solute, a precursor of the perovskite compound, has a lower solubility than in the solvent of the precursor solution. The poor solvent may be a solvent that substantially does not dissolve the precursor of the perovskite compound. The solubility of the precursor of the perovskite compound in the poor solvent at 25°C (i.e., the maximum amount of the solute that can be dissolved in 100 g of the solvent) may be, for example, less than 1 g per 100 g of the solvent, or less than 0.5 g per 100 g of the solvent.

Examples of the poor solvents include organic solvents, including substituted aliphatic hydrocarbons, such as dichloromethane and chloroform; aromatic compounds, such as toluene, benzene, chlorobenzene, and tetralin; ethers, such as diethyl ether and tetrahydrofuran (THF); alcohols with 3 or more carbon atoms; hydrocarbons with 4 to 10 carbon atoms; and acetic acid. These solvents may be used alone, or two or more of them may be used in combination. In this application, the aromatic compounds include those containing an aromatic ring as a part of their structure. In one embodiment, the poor solvent is chlorobenzene.

Applying the poor solvent onto the coating promotes the generation of crystal nuclei of the perovskite compound in the coating. The crystal nuclei grow by subsequent annealing to form grains of the perovskite compound.

The poor solvent may be applied by any application method capable of uniform application. Examples of applicable application methods include the spin coating method, the inkjet method, the spray coating method, the blade coating method, and the die coating method.

From the aspect of the stability of the precursor solution, the application of the poor solvent may be performed in a dry air atmosphere, and, in some embodiments, in an inert gas atmosphere. The inert gas may be any gas that does not react with the solute of the precursor solution. Examples of the inert gas include nitrogen and argon.

### (b) Annealing (S2)

The coating is annealed. The annealing may be performed by heating the coating at a temperature of, for example, 70°C or more and 200°C or less. By the annealing, the coating crystallizes to form the perovskite compound having a perovskite-type crystalline structure. Thus, a photoelectric conversion layer is formed.

The manufacturing method according to the embodiment may further include drying the coating to remove the solvent in the coating before annealing the coating. The drying may be performed by any drying method, such as heating the coating, blowing dry gas onto the coating, or placing the coating under reduced pressure. The drying and annealing of the coating may be performed in a single step.

Although the embodiments of the present disclosure are described in detail above, the present disclosure is not limited to these embodiments, and various design changes can be made without departing from the scope of the claims.

### EXAMPLES

The following further specifically describes the present disclosure using examples. However, the scope of the present disclosure is not limited to these examples.

### 1. Manufacturing of Photovoltaic Cell

### Comparative Example 1

A glass substrate including a photolithography-patterned indium tin oxide (ITO) film on its surface (hereinafter referred to as a "substrate" as appropriate) was prepared. The surface of the ITO film was subjected to UV-ozone treatment for 10 minutes. Poly[bis(4-phenyl)(2,4,6-trimethylphenyl)amine] (PTAA) was dissolved in dehydrated chlorobenzene to prepare a PTAA solution in chlorobenzene having a concentration of 4.5 mg/mL. The solution was filtered through a filter and applied onto the ITO film by spin coating at 2000 rpm. Next, the substrate was placed on a hot plate and annealed at 100°C. Thus, a hole transport layer was formed on the ITO film.

A precursor solution was prepared by dissolving 46.95 mg of cesium iodide (CsI), 64.74 mg of methylammonium bromide (MABr), 490.97 mg of formamidinium iodide (FAI), 192.32 mg of lead(II) bromide (PbBr₂), and 1424.46 mg of lead(II) iodide (PbI₂) in a mixed solvent of 2.4 mL of dimethylformamide (DMF) and 0.6 mL of dimethyl sulfoxide (DMSO). The precursor solution contained Cs⁺, HC(NH₂)₂⁺, CH₃NH₃⁺, Pb²⁺, I⁻, and Br⁻ in a molar ratio of 0.05:0.79:0.16:1:2.55:0.45. Namely, the precursor solution contained the cation A consisting of Cs⁺, HC(NH₂)₂⁺, and CH₃NH₃⁺, the cation B being Pb²⁺, and the anion X¹ consisting of I⁻ and Br⁻, in a molar ratio of 1:1:3.

The precursor solution was filtered through a filter and applied onto the hole transport layer by spin coating at 4000 rpm to form a coating. While the substrate was spinning, chlorobenzene was dropped onto the coating. Next, the substrate was placed on a hot plate, and the coating was annealed at 120°C. Thus, a photoelectric conversion layer was formed on the hole transport layer.

[6,6]-phenyl-C₆₁-butyric acid methyl ester (PCBM) was dissolved in dehydrated 2-propanol to prepare a PCBM solution in 2-propanol having a concentration of 25 mg/mL. The solution was filtered through a filter and applied onto the photoelectric conversion layer by spin coating at 1500 rpm. Thus, an electron transport layer was formed on the photoelectric conversion layer.

Vacuum evaporation was performed using a metal mask to form a 100 nm thick patterned silver layer on the electron transport layer. Thus, a photovoltaic cell was obtained.

### Examples 1 and 2 and Comparative Examples 2 and 3

A precursor solution was prepared by dissolving methylammonium chloride (MACl) in an amount described in Table 1, together with the same amounts of CsI, MABr, FAI, PbBr₂, and PbI₂ as in Comparative Example 1, in a mixed solvent consisting of the same amounts of DMF and DMSO as in Comparative Example 1. The precursor solution contained Cs⁺, HC(NH₂)₂⁺, CH₃NH₃⁺, Pb²⁺, I⁻, Br⁻, and Cl⁻ in a molar ratio of 0.05:0.79:(0.16+a):1:2.55:0.45:a, where the value ***a*** is described in Table 1. Namely, the precursor solution contained the cation A consisting of Cs⁺, HC(NH₂)₂⁺, and CH₃NH₃⁺, the cation B being Pb²⁺, the anion X¹ consisting of I⁻ and Br⁻, and the anion X² being Cl⁻, in a molar ratio of (1+a):1:3:a.

A photovoltaic cell was manufactured in a manner similar to Comparative Example 1 except that this precursor solution was used.

### Examples 3 to 5 and Comparative Examples 4 and 5

A precursor solution was prepared by dissolving formamidinium chloride (FACl) in an amount described in Table 1, together with the same amounts of CsI, MABr, FAI, PbBr₂, and PbI₂ as in Comparative Example 1, in a mixed solvent consisting of the same amounts of DMF and DMSO as in Comparative Example 1. The precursor solution contained Cs⁺, HC(NH₂)₂⁺, CH₃NH₃⁺, Pb²⁺, I⁻, Br⁻, and Cl⁻ in a molar ratio of 0.05:(0.79+a):0.16:1:2.55:0.45:a, where the value ***a*** is described in Table 1. Namely, the precursor solution contained the cation A consisting of Cs⁺, HC(NH₂)₂⁺, and CH₃NH₃⁺, the cation B being Pb²⁺, the anion X¹ consisting of I⁻ and Br⁻, and the anion X² being Cl⁻, in a molar ratio of (1+a):1:3:a.

A photovoltaic cell was manufactured in a manner similar to Comparative Example 1 except that this precursor solution was used.

### Example 6 and Comparative Example 6

A precursor solution was prepared by dissolving cesium chloride (CsCl) in an amount described in Table 1, together with the same amounts of CsI, MABr, FAI, PbBr₂, and PbI₂ as in Comparative Example 1, in a mixed solvent consisting of the same amounts of DMF and DMSO as in Comparative Example 1. The precursor solution contained Cs⁺, HC(NH₂)₂⁺, CH₃NH₃⁺, Pb²⁺, I⁻, Br⁻, and Cl⁻ in a molar ratio of (0.05+a):0.79:0.16:1:2.55:0.45:a, where the value ***a*** is described in Table 1. Namely, the precursor solution contained the cation A consisting of Cs⁺, HC(NH₂)₂⁺, and CH₃NH₃⁺, the cation B being Pb²⁺, the anion X¹ consisting of I⁻ and Br⁻, and the anion X² being Cl⁻, in a molar ratio of (1+a):1:3:a.

A photovoltaic cell was manufactured in a manner similar to Comparative Example 1 except that this precursor solution was used.

### Comparative Example 7

A precursor solution was prepared by dissolving 159.62 mg of CsI, 515.83 mg of FAI, and 1666.04 mg of PbI₂ in a mixed solvent of 2.4 mL of DMF and 0.6 mL of DMSO. The precursor solution contained Cs⁺, HC(NH₂)₂⁺, Pb²⁺, and I⁻ in a molar ratio of 0.17:0.83:1:3. Namely, the precursor solution contained the cation A consisting of Cs⁺ and HC(NH₂)₂⁺, the cation B being Pb²⁺, and the anion X¹ being I⁻, in a molar ratio of 1:1:3.

A photovoltaic cell was manufactured in a manner similar to Comparative Example 1 except that this precursor solution was used.

### Example 7

A precursor solution was prepared by dissolving MACl in an amount described in Table 2, together with the same amounts of CsI, FAI, and PbI₂ as in Comparative Example 7, in a mixed solvent consisting of the same amounts of DMF and DMSO as in Comparative Example 7. The precursor solution contained Cs⁺, HC(NH₂)₂⁺, CH₃NH₃⁺, Pb²⁺, I⁻, and Cl⁻ in a molar ratio of 0.17:0.83:a:1:3:a, where the value ***a*** is described in Table 2. Namely, the precursor solution contained the cation A consisting of Cs⁺, HC(NH₂)₂⁺, and CH₃NH₃⁺, the cation B being Pb²⁺, the anion X¹ being I⁻, and the anion X² being Cl⁻, in a molar ratio of (1+a):1:3:a.

A photovoltaic cell was manufactured in a manner similar to Comparative Example 1 except that this precursor solution was used.

### Example 8

A precursor solution was prepared by dissolving FACl in an amount described in Table 2, together with the same amounts of CsI, FAI, and PbI₂ as in Comparative Example 7, in a mixed solvent consisting of the same amounts of DMF and DMSO as in Comparative Example 7. The precursor solution contained Cs⁺, HC(NH₂)₂⁺, Pb²⁺, I⁻, and Cl⁻ in a molar ratio of 0.17:(0.83+a):1:3:a, where the value ***a*** is described in Table 2. Namely, the precursor solution contained the cation A consisting of Cs⁺ and HC(NH₂)₂⁺, the cation B being Pb²⁺, the anion X¹ being I⁻, and the anion X² being Cl⁻, in a molar ratio of (1+a):1 :3:a.

A photovoltaic cell was manufactured in a manner similar to Comparative Example 1 except that this precursor solution was used.

### Example 9

A precursor solution was prepared by dissolving CsCl in an amount described in Table 2, together with the same amounts of CsI, FAI, and PbI₂ as in Comparative Example 7, in a mixed solvent consisting of the same amounts of DMF and DMSO as in Comparative Example 7. The precursor solution contained Cs⁺, HC(NH₂)₂⁺, Pb²⁺, I⁻, and Cl⁻ in a molar ratio of (0.17+a):0.83:1:3:a, where the value ***a*** is described in Table 2. Namely, the precursor solution contained the cation A consisting of Cs⁺ and HC(NH₂)₂⁺, the cation B being Pb²⁺, the anion X¹ being I⁻, and the anion X² being Cl⁻, in a molar ratio of (1+a):1:3:a.

A photovoltaic cell was manufactured in a manner similar to Comparative Example 1 except that this precursor solution was used.

### 2. Measurement of Power Generation Efficiency

On the effective power generation area of a photovoltaic cell, a light-shielding mask having an opening smaller than the effective power generation area was placed. The current at each voltage was measured using a source meter, while sweeping the voltage back and forth between -0.2 V and 1.2 V, under irradiation of the cell with simulated sunlight of 1 SUN (1000 W/m²) from a solar simulator. The power generation efficiency of the photovoltaic cell was then calculated from the measured data. Table 1 illustrates the power generation efficiency of the photovoltaic cells of Examples 1 to 6 and Comparative Examples 1 to 6 normalized with respect to the power generation efficiency of the photovoltaic cell of Comparative Example 1 (i.e., the values obtained by dividing the power generation efficiency of each of the photovoltaic cells of Examples 1 to 6 and Comparative Examples 1 to 6 by that of the photovoltaic cell of Comparative Example 1). Table 2 illustrates the power generation efficiency of the photovoltaic cells of Examples 7 to 9 and Comparative Example 7 normalized with respect to the power generation efficiency of the photovoltaic cell of Comparative Example 7 (i.e., the values obtained by dividing the power generation efficiency of each of the photovoltaic cells of Examples 7 to 9 and Comparative Example 7 by that of the photovoltaic cell of Comparative Example 7).

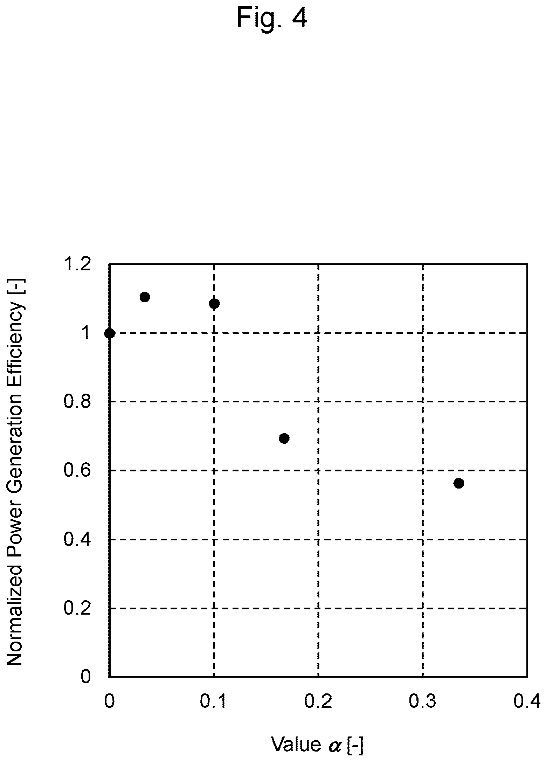

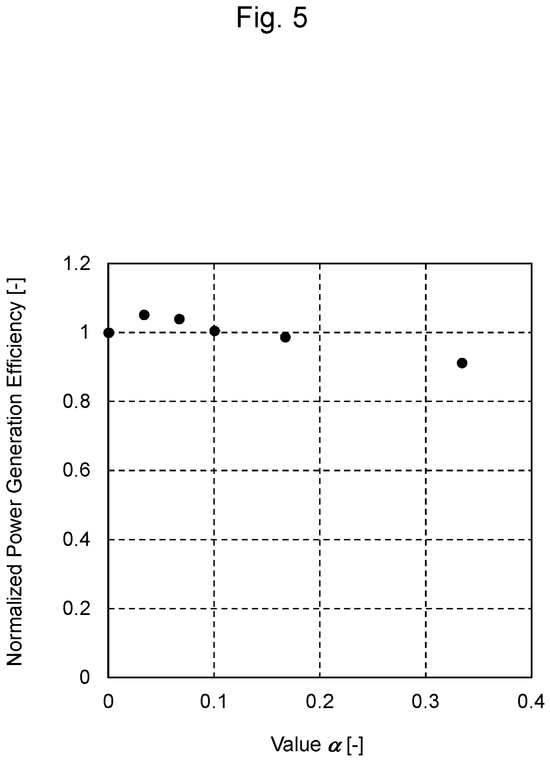

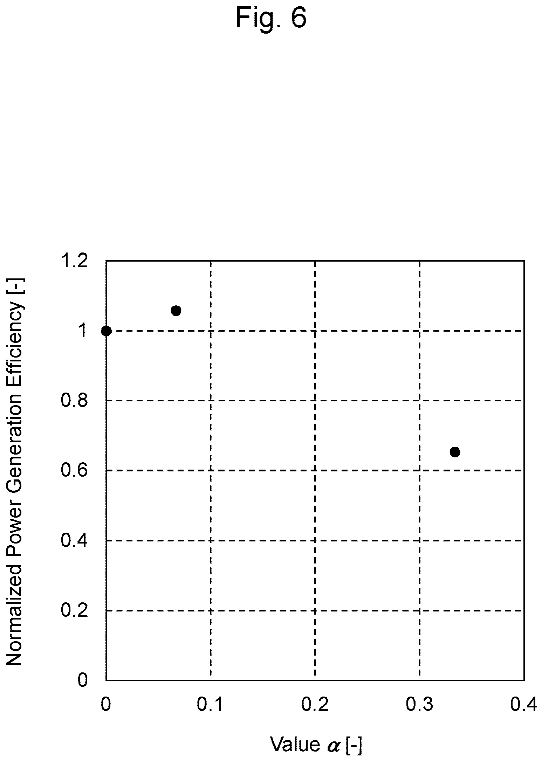

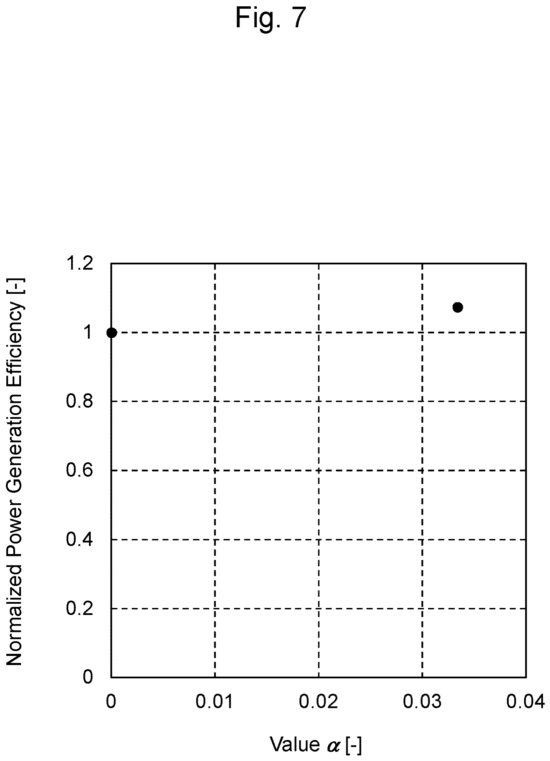

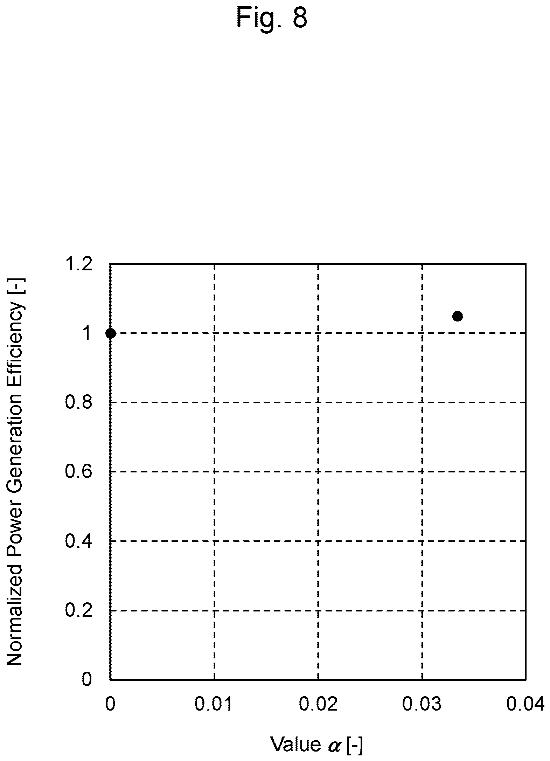

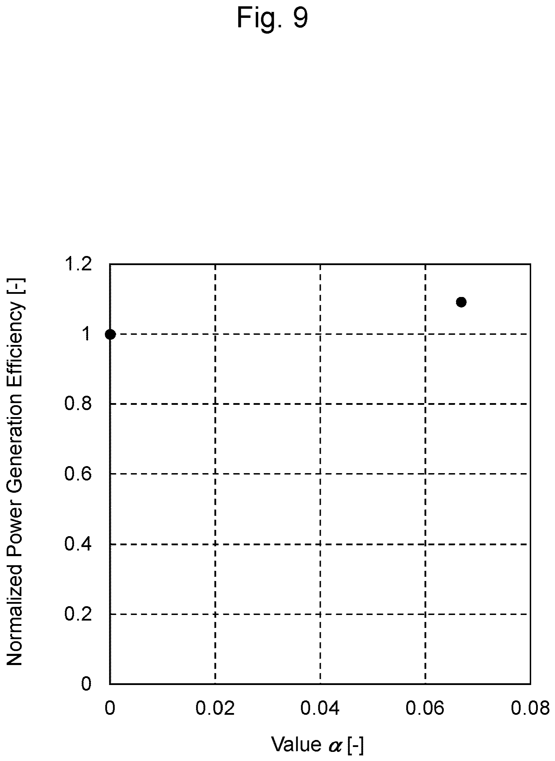

In addition, the relationship between the normalized power generation efficiency of the photovoltaic cell and the value ***a*** in the precursor solution is illustrated in the graphs in FIGS. 4 to 9. FIG. 4 illustrates the normalized power generation efficiency of the photovoltaic cells of Examples 1 and 2 and Comparative Examples 1 to 3. FIG. 5 illustrates the normalized power generation efficiency of the photovoltaic cells of Examples 3 to 5 and Comparative Examples 1, 4, and 5. FIG. 6 illustrates the normalized power generation efficiency of the photovoltaic cells of Example 6 and Comparative Examples 1 and 6. FIG. 7 illustrates the normalized power generation efficiency of the photovoltaic cells of Example 7 and Comparative Example 7. FIG. 8 illustrates the normalized power generation efficiency of the photovoltaic cells of Example 8 and Comparative Example 7. FIG. 9 illustrates the normalized power generation efficiency of the photovoltaic cells of Example 9 and Comparative Example 7.

It can be seen from Tables 1 and 2 and FIGS. 4 to 9 that the power generation efficiency improved when the value *a* was greater than 0 and less than or equal to 0.13.

**[Table 1]**

| | Added Material | Added Mass [mg] | Value ***a*** | Power Generation Efficiency [-] |
|---|---|---|---|---|
| Comparative Example 1 | None | 0 | 0 | 1.00 |
| Example 1 | MACl | 8.15 | 0.03 | 1.11 |
| Example 2 | MACl | 24.44 | 0.10 | 1.09 |
| Comparative Example 2 | MACl | 40.73 | 0.17 | 0.69 |
| Comparative Example 3 | MACl | 81.38 | 0.33 | 0.56 |
| Example 3 | FACl | 9.71 | 0.03 | 1.05 |
| Example 4 | FACl | 19.43 | 0.07 | 1.04 |
| Example 5 | FACl | 29.14 | 0.10 | 1.01 |
| Comparative Example 4 | FACl | 48.57 | 0.17 | 0.99 |
| Comparative Example 5 | FACl | 97.03 | 0.33 | 0.91 |
| Example 6 | CsCl | 40.62 | 0.07 | 1.06 |
| Comparative Example 6 | CsCl | 203.16 | 0.33 | 0.65 |

**[Table 2]**

| | Added Material | Added Mass [mg] | Value ***a*** | Power Generation Efficiency [-] |
|---|---|---|---|---|
| Comparative Example 7 | None | 0 | 0 | 1.00 |
| Example 7 | MACl | 8.15 | 0.03 | 1.07 |
| Example 8 | FACl | 9.71 | 0.03 | 1.05 |
| Example 9 | CsCl | 40.62 | 0.07 | 1.09 |

### 3. Structural Evaluation of Photoelectric Conversion Layer

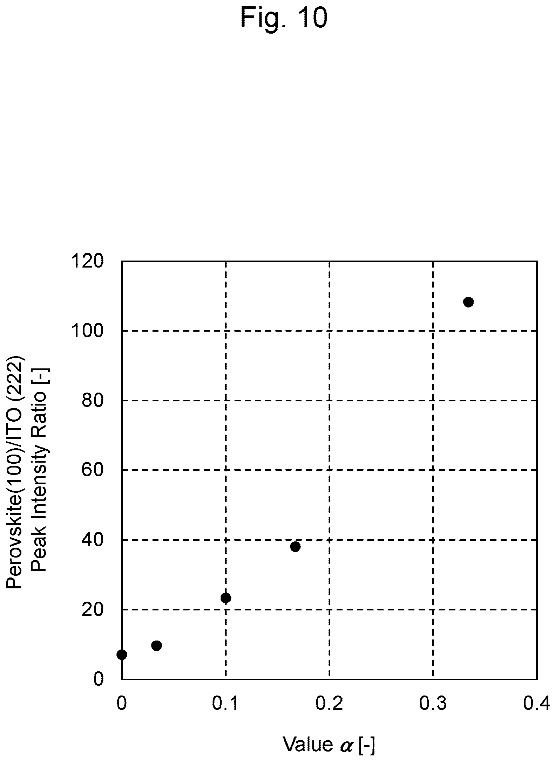

Photoelectric conversion layers were manufactured by a method similar to those of Examples 1 and 2 and Comparative Examples 1 to 3, and X-ray diffraction (XRD) measurements were performed on them using a θ-2θ scan. All the photoelectric conversion layers exhibited peaks of perovskite-type crystalline structures. FIG. 10 illustrates the ratio of perovskite (100) peak intensity (peak area) to ITO (222) peak intensity as a function of the value *a.* It was observed that the larger the value *a,* the greater the peak intensity of perovskite. Based on the simulation results described in Minjin Kim et al., "Methylammonium Chloride Induces Intermediate Phase Stabilization for Efficient Perovskite Solar Cells," Joule, Volume 3, Issue 9, 2179-2192 (2019), perovskite compound crystals containing Cl⁻ are more thermodynamically stable than perovskite compound crystals not containing Cl⁻. In view of this, it is considered that the higher content of Cl⁻ in the precursor solution (that is, the larger value ***a***) leads to higher crystallinity of the perovskite compound in the photoelectric conversion layer, which in turn resulted in the high peak intensity of perovskite.

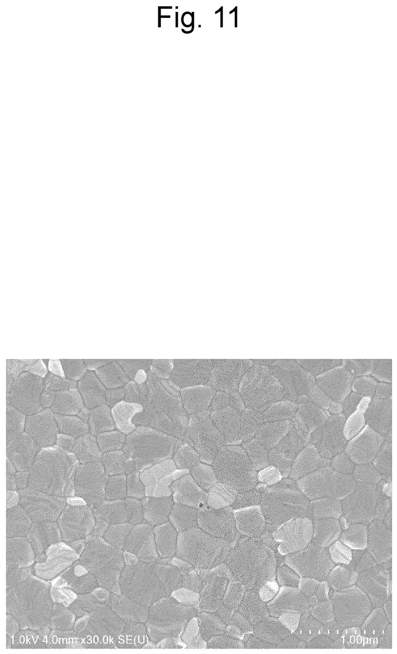

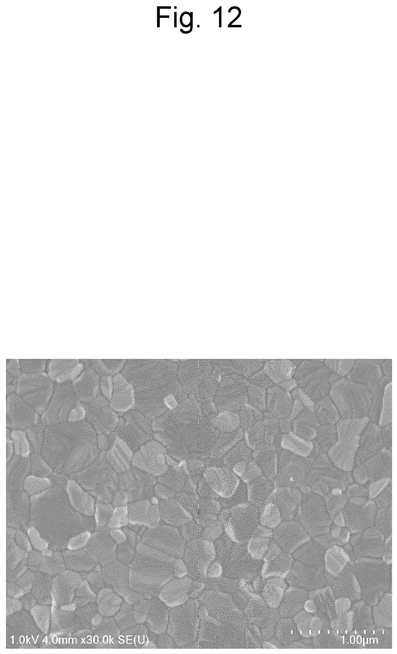

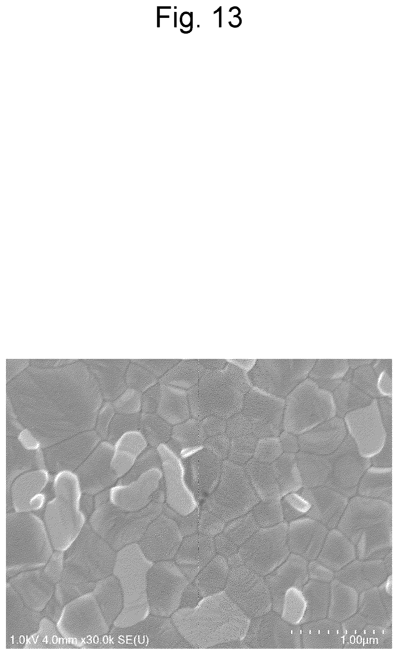

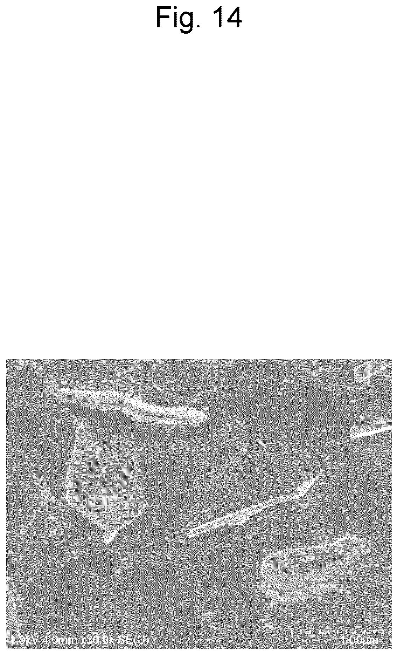

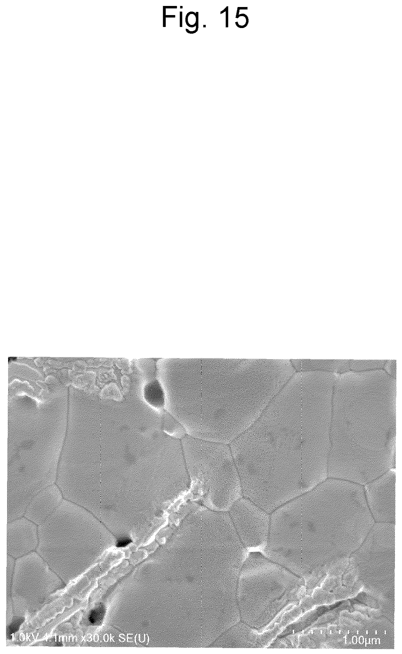

In addition, the photoelectric conversion layers manufactured by a method similar to those of Examples 1 and 2 and Comparative Examples 1 to 3 were observed by scanning electron microscope (SEM). FIGS. 11 to 15 illustrate the SEM images of the photoelectric conversion layers in Comparative Example 1 (a = 0), Example 1 (a = 0.03), Example 2 (a = 0.10), Comparative Example 2 (a = 0.17), and Comparative Example 3 (a = 0.33), respectively. In Comparative Examples 2 and 3, where the value ***a*** was 0.17 or more, it was observed that there were many film defects, such as pinholes or pits, in the photoelectric conversion layers. Further, the larger the value ***a***, the larger the grain size in the photoelectric conversion layer.

From the above results, it is considered that the power generation efficiency of the photovoltaic cell improved due to the high crystallinity of the perovskite compound in the photoelectric conversion layer when the value ***a*** was greater than 0 and less than or equal to 0.13. It is considered that when the value ***a*** was greater than 0.13, the photoelectric conversion layer had more film defects, and therefore, the power generation efficiency of the photovoltaic cell did not improve even with the high crystallinity of the perovskite compound.

### DESCRIPTION OF SYMBOLS

- 1: Substrate
- 2a: First electrode layer
- 2b: Second electrode layer
- 3a: First carrier transport layer
- 3b: Second carrier transport layer
- 4: Photoelectric conversion layer
- C: Photovoltaic cell

## Claims

1. A method for manufacturing a photovoltaic cell (C),
wherein the photovoltaic cell (C) includes:
a photoelectric conversion layer (4) containing a perovskite compound represented by formula (1) below:
ABX₃ (1),
wherein
A represents at least one cation selected from the group consisting of Cs⁺, CH₃NH₃⁺, and HC(NH₂)₂⁺,
B represents at least one divalent cation selected from the group consisting of Pb²⁺ and Sn²⁺, and
X represents at least one anion selected from the group consisting of halide anions,
the method comprising:
applying a precursor solution onto an application surface to form a coating; and
annealing the coating to form the photoelectric conversion layer (4),
wherein the precursor solution contains A, B, X¹, and X² in a molar ratio of (1+a):1:3:a,
wherein X¹ represents at least one anion selected from the group consisting of halide anions,
wherein X² represents Cl⁻, and
wherein ***a*** represents a real number greater than 0 and less than or equal to 0.13.

2. The method according to claim 1,
wherein X¹ represents at least one anion selected from the group consisting of Br and I⁻.

3. The method according to claim 1 or 2,
wherein B represents Pb²⁺.

4. The method according to any one of claims 1 to 3, further comprising
dissolving at least one compound represented by formula (2) below, at least one compound represented by formula (3) below, and at least one compound represented by formula (4) below:
AX¹ (2),
BX¹₂ (3),
and
AX² (4),
in a solvent to prepare the precursor solution.

5. The method according to any one of claims 1 to 4,
wherein ***a*** represents a real number greater than or equal to 0.03 and less than or equal to 0.1.

6. The method according to any one of claims 1 to 5,
wherein the photovoltaic cell (C) further includes, in this order, a substrate (1), a first electrode layer (2a), a first carrier transport layer (3a), a second carrier transport layer (3b), and a second electrode layer (2b), and
wherein the photoelectric conversion layer (4) is disposed between the first carrier transport layer (3a) and the second carrier transport layer (3b).

7. A precursor solution of a perovskite compound,
wherein the precursor solution contains A, B, X¹, and X² in a molar ratio of (1+a):1:3:a,
wherein A represents at least one cation selected from the group consisting of Cs⁺, CH₃NH₃⁺, and HC(NH₂)₂⁺,
wherein B represents at least one divalent cation selected from the group consisting of Pb²⁺ and Sn²⁺,
wherein X¹ represents at least one anion selected from the group consisting of halide anions,
wherein X² represents Cl⁻, and
wherein ***a*** represents a real number greater than 0 and less than or equal to 0.13.

8. The precursor solution according to claim 7,
wherein X¹ represents at least one anion selected from the group consisting of Br⁻and I⁻.

9. The precursor solution according to claim 7 or 8,
wherein B represents Pb²⁺.

10. The precursor solution according to any one of claims 7 to 9,
wherein ***a*** represents a real number greater than or equal to 0.03 and less than or equal to 0.1.
